# EUROPÄISCHE PATENTSCHRIFT

(11) **EP 0 644 589 B1**
(45) Veröffentlichungstag und Bekanntmachung des Hinweises auf die Patenterteilung: **22.10.1997**
(21) Anmeldenummer: 94112936.3
(22) Anmeldetag: 18.08.1994
(51) Int. Cl.: H01L 21/768

(54) **Verfahren zur Kontaktlochauffüllung in einem Halbleiterschichtaufbau**
Method to fill contact holes in a semiconductor layer structure
Procédé pour remplir des trous de contacts dans un ensemble de couches à semi-conducteurs

(30) Priorität: 14.09.1993 DE 4331185
(43) Veröffentlichungstag der Anmeldung: 22.03.1995
(73) Patentinhaber: SIEMENS AKTIENGESELLSCHAFT, 80333 München (DE)
(72) Erfinder: Hübner, Holger, Dr., D-85598 Baldham (DE)

(56) Entgegenhaltungen:
- EP-A- 0 517 551
- US-A- 4 624 749
- US-A- 5 151 168
- US-A- 5 227 013
- PATENT ABSTRACTS OF JAPAN vol. 015 no. 355 (E-1109) ,9.September 1991 & JP-A-03 139828

## Beschreibung

Zur Kontaktierung von Leiterbahnen in einem Halbleiterschichtaufbau werden Kontaktlöcher geöffnet, die auf die zugehörige Leiterbahn reichen. Diese Kontaktlöcher werden mit Metall aufgefüllt. Je kleiner der Querschnitt der Kontaktlöcher infolge der zunehmenden Miniaturisierung wird, desto wichtiger ist es, daß die Auffüllung der Kontaktlöcher lunkerfrei erfolgt. Eine ungleichmäßige Auffüllung der Kontaktlöcher führt zu einer Verschlechterung des Kontaktwiderstandes.

Durch kubische Integration wird eine weitere Erhöhung der Packungsdichte und eine Verkürzung der Verbindungswege in Halbleiterschaltungen erzielt. Bei der kubischen Integration werden Halbleiterschichtaufbauten, die die jeweilige integrierte Schaltung enthalten, jeweils bis auf wenige 10 µm dünngeschliffen und als Stapel, auch Stack genannt, angeordnet. Dabei können die unterschiedlichen Halbleiterebenen aus unterschiedlichen Substratmaterialien bestehen und/oder in unterschiedlichen Technologien gefertigt sein. In senkrechter Richtung müssen durch die Halbleiterschichtaufbauten hindurch Kontakte gebildet werden. Ein solcher Bauelementstapel erscheint von außen betrachtet als neuer Halbleiterbaustein. Er kann in einem Standardgehäuse mit reduzierter Anschlußzahl realisiert werden, obgleich er eine gesteigerte Funktionalität aufweist.

Die Kontakte zwischen benachbarten Ebenen bei der kubischen Integration erfolgen ebenfalls über mit Metall gefüllte Kontaktlöcher. Auch hier tritt das Problem der lunkerfreien Kontaktlochauffüllung auf.

Aus Three-Dimensional ICs Project (Fiscal 1981 - 1990), Research and Development Association for Future Electron Devices, FED, Tokyo, 1991, Kapitel 2.1, ist ein Verfahren bekannt, mit dem vertikale Kontakte zwischen in einem Stapel übereinander angeordneten Halbleiterschichtaufbauten realisiert werden können. In dem bekannten Verfahren werden auf der Oberseite eines unteren Halbleiterschichtaufbaus Wolframstifte mit einem Querschnitt von etwa 3 x 3 µm² gebildet. Diese Wolframstifte stehen 1 bis 2 µm über die Oberseite des unteren Halbleiterschichtaufbaus heraus. An einer korrespondierenden Stelle der Unterseite eines unmittelbar benachbarten, oberen Halbleiterschichtaufbaus werden großflächige Vertiefungen, die eine Abmessung von etwa 20 x 20 µm² aufweisen, erzeugt und mit einer Au/In-Legierung gefüllt. In diese gefüllten Vertiefungen tauchen die Wolframstifte beim Übereinanderstapeln des oberen Halbleiterschichtaufbaus und des unteren Halbleiterschichtaufbaus ein. Sie werden bei 300 bis 400°C verlötet. Zum Ausgleich von Oberflächentopographien und zu einer zusätzlichen mechanischen Verbindung zwischen beiden Halbleiterschichtaufbauten werden die aufeinandertreffenden Oberflächen jeweils mit einer Polyimidschicht als Kleber versehen.

Die dünnen Wolframstifte müssen bei sehr hohen Temperaturen abgeschieden werden. Das führt zu großen, punktuell angreifenden Spannungen in dem betreffenden Halbleiterschichtaufbau. Dabei kann es insbesondere bei streßempfindlichen Substratmaterialien wie GaAs oder InP zu Spannungsrissen kommen.

Der Erfindung liegt das Problem zugrunde, ein Verfahren zur Auffüllung von Kontaktlöchern in einem Halbleiterschichtaufbau anzugeben, bei dem die Kontaktlöcher lunkerfrei mit Metall gefüllt werden und bei dem mechanische Spannungen im Halbleiterschichtaufbau vermieden werden.
Dieses Problem wird erfindungsgemäß gelöst durch ein Verfahren nach Anspruch 1. Weitere Ausgestaltungen der Erfindung gehen aus den übrigen Ansprüchen hervor.

Die Auffüllung von Kontaktlöchern in einen Halbleiterschichtaufbau mittels einer galvanischen Abscheidung ist bereits aus Patent Abstracts of Japan, Vol. 015 Nr. 355 (E-1109) (entspricht JP-A-03 139 828) und US-A-5 151 168 bekannt.

Die Verwendung galvanisch abgeschiedener Schichten zur Kontaktierung ist zwar aus E. K. Yung et al, Electrochem. Soc., Vol. 136, No. 1, 1989, S. 206 - 215, im Zusammenhang mit der Herstellung von Leiterplatten bekannt. Dabei tritt jedoch das Problem der vollständigen Auffüllung von Kontaktlöchern nicht auf, da bei der Herstellung von Leiterplatten nur die Ränder von Kontaktlöchern metallisiert werden. Die Füllung mit Metall erfolgt hier bei einer späteren Lötung durch Benetzung mit einem Lot.

In dem erfindungsgemäßen Verfahren wird dagegen die Seitenwand des Kontaktlochs mit einer Isolationsstruktur bedeckt. Die zu kontaktierende Leiterbahn, die den Boden des Kontaktloches bildet, wird bei der galvanischen Abscheidung als Elektrode benutzt. Dadurch wächst bei der galvanischen Abscheidung das Metall vom Boden des Kontaktloches her auf. Die Abscheidung erfolgt praktisch nur im Bereich des Bodens des Kontaktloches. An den Seitenwänden erfolgt keine Abscheidung. Im Kontaktloch wächst lunkerfrei eine Metallschicht auf, die das Kontaktloch schließlich ausfüllt.

Nach der galvanischen Abscheidung wird die leitfähige Schicht und die darüber angeordnete isolierende Schicht durch Planarisieren der Oberfläche des Halbleiterschichtaufbaus entfernt. Dabei bleibt das Hilfskontaktloch mit Teilen der leitfähigen Schicht und der isolierenden Schicht ausgefüllt. Dadurch wird vermieden, daß das Hilfskontaktloch im Verlauf der weiteren Prozessierung einen Hohlraum bildet, in dem sich möglicherweise korrosive Prozeßmedien ansammeln könnten.

Das erfindungsgemäße Verfahren ist geeignet, gleichzeitig eine Vielzahl von Kontaktlöchern durch galvanische Abscheidung aufzufüllen. In diesem Fall werden Hilfskontaktlöcher zu allen zu kontaktierenden Leiterbahnen geöffnet, die über die leitfähige Schicht kurzgeschlossen werden.

Das erfindungsgemäße Verfahren ist ebenfalls geeignet, gleichzeitig Kontaktlöcher auf der Oberseite und der Unterseite eines Halbleiterschichtaufbaus durch galvanische Abscheidung aufzufüllen. In diesem Fall wird auf der Unterseite eine weitere leitfähige Schicht erzeugt, die über Hilfskontaktlöcher mit den zu kontaktierenden Leiterbahnen in Verbindung steht. Beide leitfähige Schichten werden bei der Abscheidung als Gegenelektrode verschaltet.

Es ist besonders vorteilhaft, bei der galvanischen Abscheidung die Leiterbahnen über die leitfähige Schicht mit Massepotential zu verbinden, da auf diese Weise sichergestellt wird, daß elektrische Ströme und Spannungen während der galvanischen Abscheidung keinen Schaden an mit den Leiterbahnen in Kontakt stehenden aktiven Strukturen des Halbleiterschichtaufbaus verursachen. Insbesondere werden elektrostatische Aufladungen vermieden, die zu Durchbrüchen im Gateoxid führen könnten.

Im folgenden wird die Erfindung anhand eines Ausführungsbeispiels und der Figuren näher erläutert.
- Figur 1: zeigt einen Halbleiterschichtbau mit einer Leiterbahn, einem Hilfskontaktloch und einer leitfähigen Schicht.
- Figur 2: zeigt den Halbleiterschichtaufbau mit einem zu füllenden Kontaktloch, dessen Seitenwand mit einer Isolationsstruktur versehen ist.
- Figur 3: zeigt den Halbleiterschichtaufbau bei der galvanischen Abscheidung einer Metallschicht in dem Kontaktloch.
- Figur 4: zeigt den Halbleiterschichtaufbau nach Entfernung der leitfähigen Schicht und Planarisierung der Oberfläche.

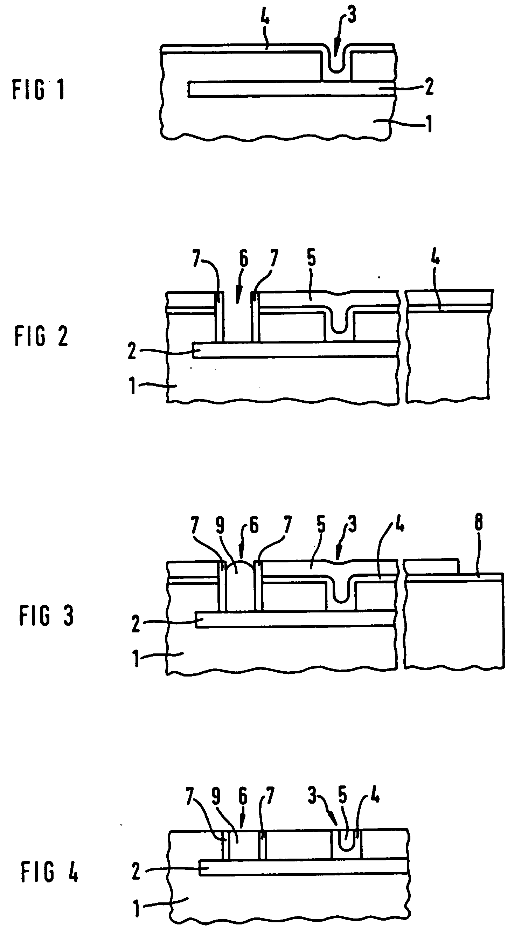

Ein Halbleiterschichtaufbau 1 umfaßt mindestens eine Leiterbahn 2 (siehe Figur 1). Der Halbleiterschichtaufbau 1 ist zum Beispiel eine Halbleiterscheibe aus einkristallinem Silizium oder einem III-V-Halbleiter. Der Halbleiterschichtaufbau 1 umfaßt Schaltungsstrukturen, die Bestandteil einer mikroelektronischen Schaltung oder einer optoelektronischen Komponente oder einer Sensorkomponente sind. Die Leiterbahn 2 ist mit mindestens einer Schaltungsstruktur verbunden.

In dem Halbleiterschichtaufbau 1 wird ein Hilfskontaktloch 3 erzeugt. Das Hilfskontaktloch 3 reicht auf die Oberfläche der Leiterbahn 2. Das Hilfskontaktloch 3 wird zum Beispiel unter Verwendung einer Photolackmaske in einem Trockenätzprozeß erzeugt. Anschließend wird die Photolackmaske wieder entfernt. Das Hilfskontaktloch 3 kann an einer beliebigen Stelle außerhalb der Position von später herzustellenden Kontaktlöchern angeordnet werden.

Anschließend wird ganzflächig eine leitfähige Schicht 4 aufgebracht. Im Bereich des Hilfskontaktloches 3 steht die leitfähige Schicht 4 mit der Leiterbahn 2 in Kontakt. Die leitfähige Schicht 4 wird mit im wesentlichen konformer Kantenbedeckung abgeschieden. Die leitfähige Schicht 4 wird zum Beispiel aus Wolfram in einer CVD-Abscheidung oder aus Gold in einer stromlosen Abscheidung hergestellt.

Es wird ganzflächig eine Photolackschicht 5 aufgebracht, die das Hilfskontaktloch 3 auffüllt. Die Photolackschicht 5 wird belichtet und entwickelt. Mit Hilfe eines Trockenätzprozesses wird ein Kontaktloch 6 zur Kontaktierung der Leiterbahn 2 erzeugt (siehe Figur 2). Im Bereich des Kontaktloches 6 liegt die Oberfläche der Leiterbahn 2 frei.

Es wird eine konforme, isolierende Schicht aus zum Beispiel SiO₂ oder Si₃N₄ abgeschieden. In einer Trockenätzung wird die isolierende Schicht auf waagerechten Oberflächen entfernt, so daß eine Isolationsstruktur 7 entsteht. Die Isolationsstruktur 7 bedeckt in Form eines Spacers lediglich die Seitenwand des Kontaktloches 6. Die Isolationsstruktur 7 isoliert das Innere des Kontaktloches 6 gegenüber der leitfähigen Schicht 4. Die Oberfläche der Leiterbahn 2 im Bereich des Kontaktloches 6 ist nur am Rand des Kontaktloches 6 durch die Isolationsstruktur 7 bedeckt und liegt im übrigen frei.

Durch eine Randentlackung wird die Photolackschicht 5 zum Beispiel am Rand des Halbleiterschichtaufbaus 1 entfernt. Dadurch wird die Oberfläche der leitfähigen Schicht 4 am Rand des Halbleiterschichtaufbaus 1 freigelegt. Der freigelegte Teil der leitfähigen Schicht 4 bildet einen Hilfskontakt 8 (siehe Figur 3).

Der Hilfskontakt 8 wird vorzugsweise mit Massepotential verbunden. Der Halbleiterschichtaufbau 1 wird in einen für eine galvanische Abscheidung geeigneten Elektrolyten eingebracht. Als Elektrolyt ist insbesondere Goldzyanid geeignet. Zwischen die bei der galvanischen Abscheidung als Kathode wirkende Leiterbahn 2 und eine ebenfalls im Elektrolyten befindliche Anode wird ein Potential von wenigen Volt zum Beispiel 1 bis 5 Volt angelegt. Das Potential wird in Abhängigkeit der Größe der freiliegenden Oberfläche und der Leitfähigkeit des Elektrolyten bestimmt. Auf der freiliegenden Oberfläche der Leiterbahn 2 wird durch galvanische Abscheidung eine Metallschicht 9 aus zum Beispiel Kupfer abgeschieden. Die Metallschicht 9 füllt das gesamte Kontaktloch 6 lunkerfrei auf.
Im folgenden wird die Photolackschicht 5 mit Lösungsmitteln entfernt. Durch Rückpolieren der Oberfläche des Halbleiterschichtaufbaus 1 wird die leitfähige Schicht 4 im wesentlichen entfernt. Dabei verbleiben in dem Hilfskontaktloch 3 Reste der leitfähigen Schicht 4 und der Photolackschicht 5. Die Größe des verbleibenden Restes der leitfähigen Schicht 4 ist so gering, daß keine Streukapazitäten, die die Funktion der Schaltung beeinträchtigen könnten, dadurch zu befürchten sind. Der Rest der Photolackschicht 5, der in dem Hilfskontaktloch 3 verbleibt, verhindert, daß sich in diesem Bereich im Verlauf der weiteren Prozessierung ein Hohlraum bildet, in dem sich möglicherweise korrosive Prozeßmedien ansammeln könnten.

Im Bereich des Kontaktloches 6 weist der Halbleiterschichtaufbau 1 (siehe Figur 4) eine planare Oberfläche auf.

In dem Ausführungsbeispiel ist der Übersichtlichkeit halber nur eine Leiterbahn, ein Kontaktloch und ein Hilfskontaktloch dargestellt. In der Praxis wird ein Halbleiterschichtaufbau eine Vielzahl von Leiterbahnen aufweisen, die jeweils über Kontaktlöcher kontaktiert werden sollen. In diesem Fall wird jede Leiterbahn über mindestens ein Hilfskontaktloch mit der leitfähigen Schicht verbunden. Die aufzufüllenden Kontaktlöcher werden jeweils mit einer Isolationsstruktur an den Seitenwänden versehen. Bei der galvanischen Abscheidung werden dann über den Hilfskontakt 8 sämtliche Leiterbahnen, die mit der leitfähigen Schicht in Verbindung stehen, als Kathode verschaltet.

Soll der Halbleiterschichtaufbau in einer kubischen Integration verschaltet werden, so werden auf gegenüberliegenden Oberflächen des Halbleiterschichtaufbaus Hilfskontaktlöcher geöffnet, die jeweils auf eine zu kontaktierende Leiterbahn reichen. Auf beide Oberflächen werden leitfähige Schichten aufgebracht, die die Leiterbahnen miteinander kurzschließen. Anschließend werden analog dem anhand der Figuren erläuterten Ausführungsbeispiel Kontaktlöcher geöffnet und mit Isolationsstrukturen versehen. Bei der galvanischen Abscheidung werden beide leitfähigen Schichten als Kathode verschaltet. Auf diese Weise wird in einem Arbeitsgang auf beiden gegenüberliegenden Oberflächen die Kontaktlöcher aufgefüllt. Anschließend werden die Photolackschicht und die leitfähige Schicht auf beiden Oberflächen mit Hilfe planarisierender Verfahren, zum Beispiel durch Polieren, entfernt.

## Patentansprüche

1. Verfahren zur Auffüllung mindestens eines Kontaktloches in einem Halbleiterschichtaufbau, der Schattungsstrukturen umfaßt,
- bei dem in einem ersten Teil einer ersten Oberfläche des Halbleiterschichtaufbaus (1) mindestens ein Hilfskontaktloch (3) geöffnet wird, in dem die Oberfläche einer ersten mit mindestens einer der Schaltungsstruktur verbundenen Leiterbahn (2) freigelegt wird,
- bei dem ganzflächig eine leitfähige Schicht (4) aufgebracht wird, die eine im wesentlichen konforme Kantenbedeckung aufweist,
- bei dem auf die leitfähige Schicht (4) eine isolierende Schicht (5) aufgebracht wird, die mindestens im Bereich des Hilfskontaktlochs (3) planarisierend ist und die das Hilfskontaktloch (3) auffüllt,
- bei dem in einem zweiten Teil der ersten Oberfläche das Kontaktloch (6) geöffnet wird, in dem die Oberfläche der ersten Leiterbahn (2) freigelegt wird,
- bei dem die Seitenwände des Kontaktloches (6) mit einer Isolationsstruktur (7) bedeckt werden,
- bei dem außerhalb des Kontaktloches (6) und des Hilfskontaktloches ein Hilfskontakt (8) zu der leitfähigen Schicht (4) hergestellt wird, und
- bei dem das Kontaktloch (6) durch galvanische Abscheidung in einem Elektrolyten mit Metall (9) aufgefüllt wird, wobei die erste Leiterbahn (2) über den Hilfskontakt (8) zur leitfahigen Schicht (4) als Gegenelektrode verschaltet wird.

2. Verfahren nach Anspruch 1,
bei dem bei der galvanischen Abscheidung der Hilfskontakt (8) zur leitfähigen Schicht (4) mit Massepotential verbunden wird.

3. Verfahren nach Anspruch 1 oder 2,
bei dem nach der galvanischen Abscheidung die isolierende Schicht (5) und die leitfähige Schicht (4) durch Planarisieren der Oberfläche des Halbleiterschichtaufbaus (1) im wesentlichen entfernt werden.

4. Verfahren nach einem der Ansprüche 1 bis 3,
- bei dem vor dem Aufbringen der leitfähigen Schicht zu mindestens einer zweiten Leiterbahn mindestens ein weiteres Hilfskontaktloch geöffnet wird, in dem die Oberfläche der zweiten Leiterbahn freigelegt wird,
- bei dem die erste Leiterbahn und die zweite Leiterbahn über die leitfähige Schicht elektrisch kurzgeschlossen werden,
- bei dem vor der galvanischen Abscheidung ein weiteres Kontaktloch geöffnet wird, in dem die Oberfläche der zweiten Leiterbahn freigelegt wird,
- bei dem die Seitenwände des weiteren Kontaktloches mit einer weiteren Isolationsstruktur bedeckt werden, und
- bei dem auch das weitere Kontaktloch bei der galvanischen Abscheidung mit Metall aufgefüllt wird.

5. Verfahren nach einem der Ansprüche 1 bis 4,
- bei dem die isolierende Schicht (5) aus Photolack gebildet wird, und
- bei dem nach Belichtung und Entwicklung der isolierenden Schicht (5) aus Photolack diese als Ätzmaske zur Öffnung der Kontaktlöcher mit Hilfe eines anisotropen Trockenätzprozesses verwendet wird.

6. Verfahren nach Anspruch 5,
bei dem zur Herstellung des Hilfskontaktes (8) zur der leitfähigen Schicht (4) eine Entlackung am Rand des Halbleiterschichtaufbaus durchgeführt wird.

7. Verfahren nach einem der Ansprüche 1 bis 6,
bei dem die leitfähige Schicht (4) in einer CVD-Abscheidung aus Wolfram oder einer stromlosen Abscheidung aus Gold gebildet wird.

8. Verfahren nach einem der Ansprüche 1 bis 7,
bei dem die Isolationsstruktur bzw.-strukturen an den Seitenwänden der Kontaktlöcher durch ganzflächiges Abscheiden einer Isolationsschicht mit im wesentlichen konformer Kantenbedeckung und anisotropes Ätzen der Isolationsschicht gebildet wird bzw. werden.

9. Verfahren nach einem der Ansprüche 1 bis 8,
- bei dem zur Auffüllung von weiteren Kontaktlöchern in einer zweiten Oberfläche des Halbleiterschichtaufbaus, die der ersten Oberfläche gegenüberliegt, in der zweiten Oberfläche weitere Hilfskontaktlöcher geöffnet werden, die jeweils auf die Oberfläche von weiteren zu kontaktierenden Leiterbahnen reichen,
- bei dem auf die zweite Oberfläche ganzflächig eine weitere leitfähige Schicht mit im wesentlichen konformer Kantenbedeckung abgeschieden wird,
- bei dem auf die weitere leitfähige Schicht eine weitere isolierende Schicht aufgebracht wird, die mindestens im Bereich der weiteren Hilfskontaktlöcher planarisierend ist und die die weiteren Hilfskontaktlöcher auf füllt,
- bei dem die weiteren Kontaktlöcher geöffnet werden, in denen die Oberfläche der jeweils zu kontaktierenden Leiterbahnen freigelegt wird,
- bei dem die Seitenwände der weiteren Kontaktlöcher mit Isolationsstrukturen bedeckt werden,
- bei dem außerhalb der weiteren Kontaktlöcher und weiteren Hilfskontaktlöcher ein Kontakt zu der weiteren leitfähigen Schicht hergestellt wird,
- bei dem die weiteren Kontaktlöcher durch galvanische Abscheidung in einem Elektrolyten mit Metall aufgefüllt weden, wobei die weiteren Leiterbahnen über den Kontakt zur weiteren leitfähigen Schicht als Gegenelektrode verschaltet werden, und
- bei dem nach der galvanischen Abscheidung die weitere isolierende Schicht und die weitere leitfähige Schicht durch Planarisieren der zweiten Oberfläche des Halbleiterschichtaufbaus im wesentlichen entfernt werden.

10. Verfahren nach Anspruch 9,
bei dem bei der galvanischen Abscheidung der Kontakt zu der weiteren leitfähigen Schicht mit Massepotential verbunden wird.

## Claims

1. Method for filling at least one via hole in a semiconductor layer structure which comprises circuit structures,
- in which at least one auxiliary via hole (3), in which the surface of a first interconnect (2) connected to at least one of the circuit structures is exposed, is opened in a first part of a first surface of the semiconductor layer structure (1) ,
- in which a conductive layer (4) having essentially conforming edge coverage is applied over the entire area,
- in which an insulating layer (5) is applied to the conductive layer (4), the said insulating layer having a planarizing effect at least in the region of the auxiliary via hole (3) and filling the auxiliary via hole (3),
- in which the via hole (6), in which the surface of the first interconnect (2) is exposed, is opened in a second part of the first surface,
- in which the side walls of the via hole (6) are covered with an insulating structure (7),
- in which an auxiliary contact (8) to the conductive layer (4) is produced outside the via hole (6) and the auxiliary via hole, and
- in which the via hole (6) is filled with metal (9) by electrodeposition in an electrolyte, the first interconnect (2) being connected as a counter-electrode via the auxiliary contact (8) to the conductive layer (4).

2. Method according to Claim 1, in which the auxiliary contact (8) to the conductive layer (4) is connected to earth potential during electrodeposition.

3. Method according to Claim 1 or 2, in which, after electrodeposition, the insulating layer (5) and the conductive layer (4) are essentially removed by planarizing the surface of the semiconductor layer structure (1).

4. Method according to one of Claims 1 to 3, in which, before the conductive layer is applied, at least one further auxiliary via hole is opened to at least a second interconnect, in which further auxiliary via hole the surface of the second interconnect is exposed,
- in which the first interconnect and the second interconnect are electrically short-circuited via the conductive layer,
- in which, before electrodeposition, a further via hole, in which the surface of the second interconnect is exposed, is opened,
- in which the side walls of the further via hole are covered with a further insulating structure, and
- in which the further via hole is also filled with metal during electrodeposition.

5. Method according to one of Claims 1 to 4,
- in which the insulating layer (5) is formed from photoresist, and
- in which, after the exposure and development of the insulating layer (5) formed from photoresist, the latter is used as an etching mask for opening the via holes by means of an anisotropic dry-etching process.

6. Method according to Claim 5, in which delacquering is carried out at the edge of the semiconductor layer structure in order to produce the auxiliary contact (8) to the conductive layer (4).

7. Method according to one of Claims 1 to 6, in which the conductive layer (4) is formed from tungsten by CVD deposition or from gold by currentless deposition.

8. Method according to one of Claims 1 to 7, in which the insulating structure or insulating structures is or are formed on the side walls of the via holes by the deposition of an insulating layer over the entire area, with essentially conforming edge coverage, and by anisotropic etching of the insulating layer.

9. Method according to one of Claims 1 to 8,
- in which, to fill further via holes in a second surface of the semiconductor layer structure which is located opposite the first surface, further auxiliary via holes are opened in the second surface, each extending to the surface of further interconnects to be contacted,
- in which a further conductive layer with essentially conforming edge coverage is deposited onto the entire area of the second surface,
- in which a further insulating layer is applied to the further conductive layer, the said insulating layer having a planarizing effect at least in the region of the further auxiliary via holes and filling the further auxiliary via holes,
- in which the further via holes, in which the surface of the interconnects to be contacted in each case is exposed, are opened,
- in which the side walls of the further via holes are covered with insulating structures,
- in which a contact to the further conductive layer is produced outside the further via holes and further auxiliary via holes,
- in which the further via holes are filled with metal by electrodeposition in an electrolyte, the further interconnects being connected as a counter-electrode via the contact to the further conductive layer, and
- in which, after electrodeposition, the further insulating layer and the further conductive layer are essentially removed by planarizing the second surface of the semiconductor layer structure.

10. Method according to Claim 9, in which the contact to the further conductive layer is connected to earth potential during electrodeposition.

## Revendications

1. Procédé de remplissage d'au moins un trou de. contact dans un ensemble de couches à semi-conducteurs, qui comprend des structures de circuit,
- dans lequel dans une première partie d'une première surface de l'ensemble de couches à semi-conducteurs (1), au moins un trou de contact auxiliaire (3) est ouvert, dans lequel la surface d'une première piste conductive (2) reliée à au moins une des structures de circuit est dégagée,
- dans lequel une couche conductrice (4), présentant un recouvrement des bords essentiellement conforme, est appliquée sur toute la surface,
- dans lequel une couche isolante (5) qui a un effet d'aplanissement au moins dans la zone du trou de contact auxiliaire (3) et qui remplit le trou de contact auxiliaire (3), est appliquée sur la couche conductrice (4),
- dans lequel dans une deuxième partie de la première surface, le trou de contact (6) est ouvert, trou dans lequel la surface de la piste conductive (2) est dégagée,
- dans lequel les parois latérales du trou de contact (6) sont recouvertes d'une structure d'isolation (7),
- dans lequel hors du trou de contact (6) et du trou de contact auxiliaire, un contact auxiliaire (8) à la couche conductrice (4) est créé, et
- dans lequel le trou de contact (6) est rempli de métal par déposition galvanique dans un électrolyte, la première piste conductive (2) étant couplée comme contre-électrode à la couche conductrice (4) au moyen du contact auxiliaire (8).

2. Procédé selon la revendication 1, dans lequel, lors de la déposition galvanique, le contact auxiliaire (8) à la couche conductrice (4) est relié au potentiel de masse.

3. Procédé selon la revendication 1 ou 2, dans lequel après la déposition galvanique, la couche isolante (5) et la couche conductrice (4) sont essentiellement éliminées par aplanissement de la surface de l'ensemble de couches à semi-conducteurs (1).

4. Procédé selon l'une des revendications 1 à 3,
- dans lequel avant l'application de la couche conductrice à au moins une deuxième piste conductive, au moins un autre trou de contact auxiliaire est ouvert, dans lequel la surface de la deuxième piste conductive est dégagée,
- dans lequel la première piste conductive et la deuxième piste conductive sont mises en court-circuit électriquement au moyen de la couche conductrice,
- dans lequel avant la déposition galvanique, un autre trou de contact est ouvert, dans lequel la surface de la deuxième piste conductive est dégagée,
- dans lequel les parois latérales de l'autre trou de contact sont recouvertes d'une autre structure d'isolation, et
- dans lequel l'autre trou de contact est aussi rempli de métal lors de la déposition galvanique.

5. Procédé selon l'une des revendications 1 à 4,
- dans lequel la couche isolante (5) est constituée de laque photosensible, et
- dans lequel après exposition et développement de la couche isolante (5) en laque photosensible, celle-ci est utilisée comme masque de gravure pour l'ouverture des trous de contact à l'aide d'un processus de gravure anisotrope à sec.

6. Procédé selon la revendication 5, dans lequel un enlèvement de laque au bord de l'ensemble de couches à semi-conducteurs est exécuté pour la création du contact auxiliaire (8) à la couche conductrice (4).

7. Procédé selon l'une des revendications 1 à 6, dans lequel la couche conductrice (4) est constituée de tungstène dans une déposition CVD ou d'or dans une déposition sans courant.

8. Procédé selon l'une des revendications 1 à 7, dans lequel la structure resp. les structures d'isolation est resp. sont formée(s) sur les parois latérales des trous de contact par déposition sur toute la surface d'une couche d'isolation avec un recouvrement des bords essentiellement conforme et par gravure anisotrope de la couche d'isolation.

9. Procédé selon l'une des revendications 1 à 8,
- dans lequel, pour le remplissage d'autres trous de contact situés dans une deuxième surface de l'ensemble de couches à semi-conducteurs, qui fait face à la première surface, d'autres trous de contact auxiliaire sont ouverts dans la deuxième surface, qui atteignent à chaque fois la surface d'autres pistes conductives à mettre en contact,
- dans lequel une autre couche conductrice comportant un recouvrement des bords essentiellement conforme est déposée sur toute la surface de la deuxième surface,
- dans lequel une autre couche isolante, qui a un effet d'aplanissement au moins dans la zone des autres trous de contact auxiliaire et qui remplit les autres trous de contact auxiliaire, est appliquée sur l'autre couche conductrice,
- dans lequel les autres trous de contact sont ouverts, dans lesquels la surface des pistes conductives à mettre en contact à chaque fois est dégagée,
- dans lequel les parois latérales des autres trous de contact sont recouvertes de structures d'isolation,
- dans lequel à l'extérieur des autres trous de contact et des autres trous de contact auxiliaire, un contact à l'autre couche conductrice est créé,
- dans lequel les autres trous de contact sont remplis de métal par déposition galvanique dans un électrolyte, les autres pistes conductives étant couplées comme contre-électrode au moyen du contact à l'autre couche conductrice, et
- dans lequel après la déposition galvanique, l'autre couche isolante et l'autre couche conductrice sont essentiellement éliminées par aplanissement de la deuxième surface de l'ensemble de couches à semi-conducteurs.

10. Procédé selon la revendication 9, dans lequel lors de la déposition galvanique, le contact à l'autre couche conductrice est relié au potentiel de masse.
